Europäisches Patentamt

European Patent Office

Office européen des brevets

(11) Publication number: **0 040 076**
**B1**

## (12) EUROPEAN PATENT SPECIFICATION

(45) Date of publication of patent specification: **20.03.85**

(51) Int. Cl.⁴: **H 01 L 31/02, H 01 L 27/14**

(21) Application number: **81302071.6**

(22) Date of filing: **08.05.81**

(54) **Photoelectric converter.**

(30) Priority: **09.05.80 JP 60620/80**

(43) Date of publication of application:
**18.11.81 Bulletin 81/46**

(45) Publication of the grant of the patent:
**20.03.85 Bulletin 85/12**

(84) Designated Contracting States:
**DE FR GB NL**

(56) References cited:
**EP-A-0 029 679**
**EP-A-0 030 476**
**EP-A-0 033 230**
**FR-A-2 433 871**

(73) Proprietor: **Hitachi, Ltd.**
**5-1, Marunouchi 1-chome**
**Chiyoda-ku Tokyo 100 (JP)**

(72) Inventor: **Sasano, Akira**
**2196-450 Hirai**
**Hinodemachi Nishitama-gun Tokyo (JP)**
Inventor: **Shimomoto, Yasuharu**
**2196-92 Hirai**
**Hinodemachi Nishitama-gun Tokyo (JP)**
Inventor: **Tanaka, Yasuo**
**1-217 Higashi-Koigukubo**
**Kokubunji-shi Tokyo (JP)**
Inventor: **Tanaka, Toshihiro**
**1-48-18 Akatsuki-cho**
**Hachioji-shi Tokyo (JP)**
Inventor: **Tsukada, Toshihisa**
**4-kou704-17-B405 Sekimachi**
**Nerima-ku Tokyo (JP)**

(74) Representative: **Paget, Hugh Charles Edward et al**
**MEWBURN ELLIS & CO. 2/3 Cursitor Street**
**London EC4A 1BQ (GB)**

## Description

The present invention relates to a photoelectric converter comprising photoelectric conversion means formed on a substrate, said photoelectric conversion means including at least a first electrode, a hydrogenated amorphous silicon layer formed on said first electrode, the silicon in the layer being optionally substituted by at least one of germanium and carbon and a second electrode in the form of a transparent conductive layer composed of $In_2O_3$ or a solid solution of $In_2O_3$ and $SnO_2$ end formed on said silicon layer.

The photoelectric converter of the invention is particularly suitable for use in a solid state image pick up device having a photoconductive layer formed on a semiconductor substrate provided with an electronic circuit.

A solid state image pick up device has a plurality of solid state elements having photoelectric conversion and signal storage functions. These solid state elements constitute an image pickup surface of picture elements each corresponding to one solid state element. The external image is converted into electrical signals by successive scanning of the image pickup surface. The photoconductive layer of the image pickup surface covers a semiconductor substrate on which are formed switches, scanning circuitry and so forth.

A known solid state image pickup device of this type incorporates a photoconductive layer made of hydrogenated amorphous silicon (referred to hereinafter as a-Si:H). A typical example of such a device is disclosed in our Japanese Laid Open Patent Application No. 39404/80.

An object of the invention is to provide a transparent conductive film on a photoconductive layer in a solid state image pickup device in which the transparent conductive layer is free from the problem of peeling from the photoconductive layer. It is further desirable that the conductive film has a conductivity which renders it useful in practice.

According to the invention the thickness of said transparent conductive layer is selected to be in the range 30 to 200 nm.

In this specification (including the claims) we use the term amorphous silicon to include materials containing Ge or C in part-substitution for the Si, as discussed further below.

Embodiments of the invention will now be described by way of example with reference to the accompanying drawings, in which:—

Fig. 1 is a sectional view of a picture element portion of a photoelectric converter embodying the invention;

Figs. 2a to 2f are sectional views of the picture element portion of Fig. 1, in different stages of manufacture;

Fig. 3 shows a sputtering device;

Fig. 4 is a graph showing how the peeling off and sheet resistance ratio of the transparent conductive layer vary with the thickness of this layer; and

Fig. 5 is a sectional view of another photoelectric converter embodying the invention.

It has been found that, when a-Si:H is used for a photoconductive layer as described above, a transparent conductive film formed on the a-Si:H layer tends to peel off, while this problem is not so noticeable when a transparent conductive film is formed on photoconductive layers of other materials such as Se-system materials. The reason for this difference has not yet been clarified.

In general, $In_2O_3$ and solid solutions of $In_2O_3$ and $SnO_2$ (referred to as ITO hereinafter) are used for the transparent conductive films of devices such as image pickup tubes. In an image pickup tube, the transparent conductive film is first formed on a substrate and then the photoconductive layer is formed on the film. So, an image pickup tube is free from the problem of peeling off of the transparent conductive layer, to which the present invention pertains. The construction of the ITO film in an image pickup tube is described for example in Japanese Laid open Patent Application No. 26025/1973.

In order to find an effective way of preventing the peeling of a transparent conductive film from an a-Si:H layer, various attempts have been made in experiments using a large variety of films. As a result, the present inventors have found that a solid state image pickup device which is usable in practice can be obtained by using $In_2O_3$ or a solid solution (ITO) of $In_2O_3$ and $SnO_2$ and selecting the film thickness between 30 and 200 nm (300Å and 2000Å).

The ITO preferably has an $In_2O_3$ content of 80 mole % or higher. It is possible to use $In_2O_3$ alone but the use of ITO is preferred because it has lower specific resistance which gives a higher performance of the transparent electrode. The most preferred ITO used in the invention has an $In_2O_3$ content of between 89 mole % and 95 mole %.

The ITO film formed on the a-Si:H layer should have a thickness of not greater than 200 nm (2000Å) because, the level of stress in such a film is so low that no peeling from the a-Si:H film is caused. When the film thickness exceeds 30 nm (300Å), the film is free from the influence of the surface condition of the underlying layer, and has a constant resistance value.

More specifically, the height of the step between the wiring on the semiconductor substrate of an ordinary solid state image pickup device and the insulating coating film formed on the wiring is usually about 1 μm. When the a-Si:H layer is formed on this, the step height in the a-Si layer is about 100 nm (1000Å). An ITO layer formed on the a-Si layer to a thickness of at least 30 nm (300Å) can sufficiently reduce the step height to provide a resistance value which is substantially equal to that achieved when there is no step. Therefore, a transparent conductive film of thickness between 30 and 200 nm (300 and 2000Å) can provide a transparent electrode which does not peel from the a-Si:H layer and has a stable resistance value.

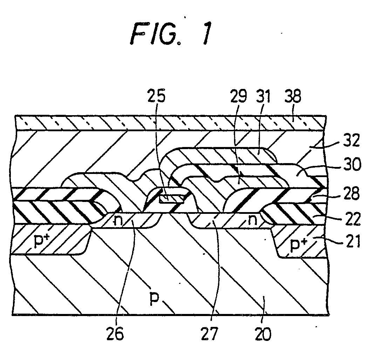

In the device of Fig. 1, a MOS transistor is formed on a P type silicon substrate 20. A $P^+$ type conductive region 21 and oxide film 22 are provided for isolation, while oxide films 28 and 30 are formed as insulation. Aluminum electrodes 31, 29 are formed on the source region 26 and the drain region 27. A gate electrode 25 is formed of polycrystalline Si. These elements constitute a semiconductor substrate which is generally referred to as an IC or LSI. Although only a single element is shown, a multiplicity of such elements are arranged two-dimensionally, usually in the form of a matrix. Electronic circuits such as switch circuits, scanning circuits and so forth are formed on the common substrate.

A photoconductive layer 32 of a-Si:H is formed on this semiconductor substrate. The a-Si:H layer is formed by reactive sputtering in an atmosphere which is a mixture of hydrogen and an inert gas such as argon. To this end, a low temperature and high-speed sputtering device of the magnetron type is suitably used. An amorphous silicon film containing hydrogen releases a hydrogen and is transformed when heated to above 350°C, so the substrate is preferably maintained at between 100 and 300°C during formation of the film. The hydrogen concentration in the film can be varied widely by changing the partial pressure of hydrogen in the atmosphere under the electric discharge which generally has a pressure between 0.266 and 13.3 Pa ($2 \times 10^{-3}$ and $1 \times 10^{-1}$ Torr). A sintered body of silicon or the like material is used as the target in the sputtering and if necessary, boron as a P-type may be included. Similarly, phosphorus as an N-type impurity may be added to the material of the target. It is also possible to use a sintered admixture of silicon and germanium as the material of the target.

In order that the amorphous film thus formed is suitable for use as a light receiving device of storage mode, the film preferably has a specific resistance of not less than $10^{10}$ Ω cm and a small trap density. To this end, the hydrogen content of the film is preferably between 5 and 50 atomic%, more preferably between 5 and 30 atomic% and most preferably between 10 and 25 atomic%. Good results are obtained when the silicon content is greater than 50 atomic%. The silicon can be partially substituted by at least one of germanium and carbon (which are the elements of the same group as silicon). The amount of substitution preferably is less than 30% of the silicon.

A hydrogen content which is too low causes an excessively low resistance, resulting in deterioriation in the resolution. In contrast, too high a hydrogen content reduces the photoconductivity so that the photoconductive characteristic deteriorates.

A transparent electrode 38 consisting of a solid solution of $In_2O_3$ and $SnO_2$ is formed on the photoconductive layer 32, to a thickness of between 30 and 200 nm (300 and 2000Å). This electrode is formed by sputtering using a solid solution of $In_2O_3$ and $SnO_2$ mixed in the ratio of 91:9 as the target material. During the sputtering, the semiconductor substrate is mounted on a support plate which is water cooled to 40 to 50°C. At such a low temperature, the transparent electrode can be formed without thermally affecting the photoconductive layer 32 and the circuit portion of the substrate.

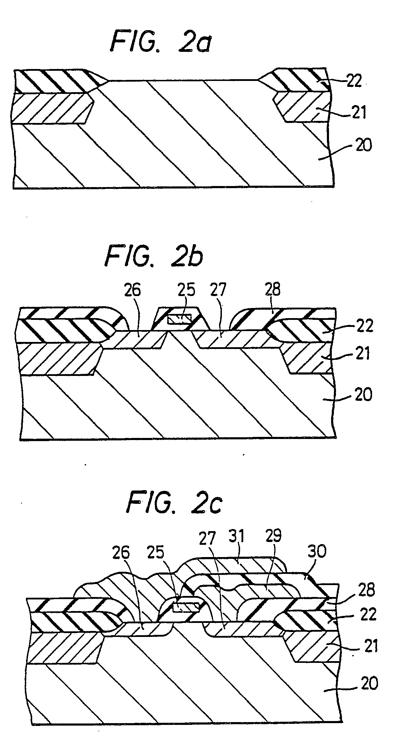

In Figs. 2a to 2f the same reference numerals are used to denote the same parts as in Fig. 1.

In the first step, a P-type diffusion region 21 is formed in a P-type silicon substrate by a known ion implantation method. This region 21 is intended to achieve a better separation of the elements. Then, the silicon is locally oxidized in an atmosphere containing $H_2$ and $O_2$ gases at a ratio of $H_2:O_2 = 1:8$, to form an $SiO_2$ layer 22 (Fig. 2a). This method is generally referred to as LOCOS and locally oxidizes the silicon to ensure the isolation of elements. Then, a gate insulating film of the MOS transistor is formed of $SiO_2$, and a gate 25 of poly-silicon and diffusion regions 26, 27 are formed. Thereafter, an $SiO_2$ film 28 is formed to cover the gate 25 and the diffusion regions. Windows are formed in the film 28 by etching for the leads of the source 26 and the drain 27 (Fig. 2b). Then, an Al layer 800 nm (8000Å) thick is formed by evaporation to form the drain electrode 29.

An $SiO_2$ film 30 is formed to a thickness of 750 nm (7500Å) and thereafter an Al layer 1 μm thick constituting a source electrode 31 is formed by evaporation. The electrode 31 has an area sufficiently large to cover the regions 26, 27 and the gate 25, in order to avoid undesirable phenomena such as glooming which would otherwise be caused by light coming into the signal processing region between the diffusion layers 21 isolating the elements.

After this formation of the MOS transistor as a switch on the semiconductor substrate 20 as illustrated, the substrate surface has concavities and convexities.

Peripheral driving circuits such as shift registers or the like, are formed simultaneously on the periphery of the light receiving section.

The MOS transistor of the scanning circuit is thus completed, and the light receiving section is then formed on this MOS transistor.

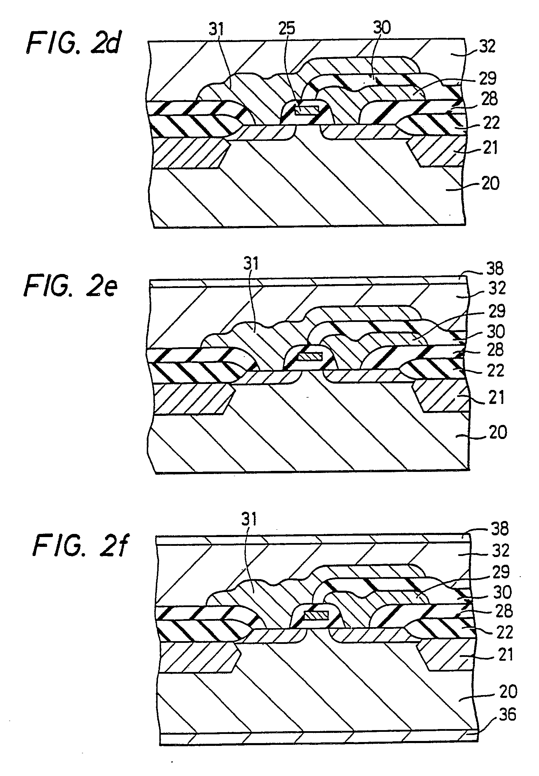

Fig. 2d shows that an a-Si:H layer 32 having a high resistance and a thickness of between 1 and 5 μm is formed on the substrate by reactive sputtering of silicon in a hydrogen atmosphere, at an electric discharge power of 300W (substrate temperature between room temperature and 250°C). The atmosphere contains argon (Ar) at a partial pressure of 0.4 Pa ($3 \times 10^{-3}$ Torr), and hydrogen (H) at a partial pressure of 0.266 Pa ($2 \times 10^{-3}$ Torr) (i.e. 40% hydrogen by partial pressure). The hydrogen content in the film is 15 atom%. This a-Si:H layer has a high resistance of $10^{12}$ to $10^{13}$ Ω cm.

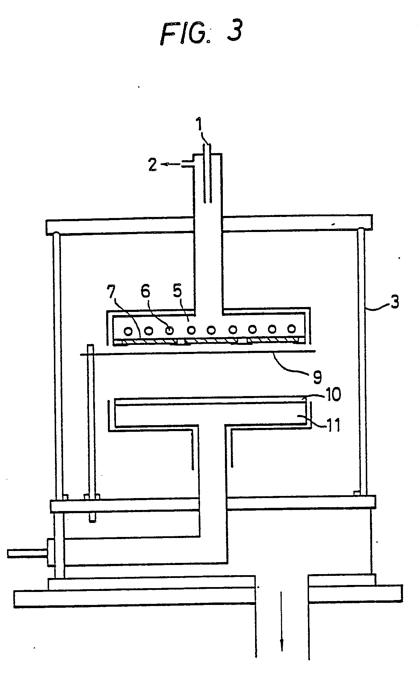

Thereafter (Fig. 2e), a transparent conductive film 38 is formed to a thickness of 30 to 200 nm (300 to 2000Å) by sputtering performed by an ordinary high-frequency sputtering device whose details are shown in Fig. 3.

As Fig. 3 shows, the semiconductor substrate 7 having an amorphous conductive film is held by a substrate holder 5. The space in a bell-jar 3 is first evacuated and then charged with Ar gas up to a pressure of 0.133 Pa (1.0 × 10⁻³ Torr). Then, cooling water is circulated through a cooling water pipe 6 in the substrate holder 5, via a substrate cooling water inlet 1. After cooling the water is discharged via a water outlet 2. The shape of the cooling water passage is omitted. As a result of this cooling, the substrate temperature is maintained at a level of not higher than 60°C.

A solid solution of $In_2O_3$ and $SnO_2$ at a ratio of $In_2O_3:SnO_2 = 91:9$ mole% or $95:5$ wt% was used as the target (10). The distance between electrodes was 30 to 60 mm. As the inert gas, Ar gas of partial pressure of 0.666 to 0.066 Pa ($5.0 \times 10^{-3}$ to $5.0 \times 10^{-4}$ Torr) was used. In order to avoid the creation of energetic ions by sputtering, the sputtering power was 100 to 150 Watt (0.55) to 0.83 Watt/cm²). For instance, when the sputtering time was 45 minutes, the thickness of the film obtained was 60 ± 5 nm (600 ± 50Å). In order to improve the reproducibility of the resistance value, a pre-sputter was effected for 60 minutes before the sputtering itself. The specimen surface temperature during the sputtering was measured at 40 to 50°C.

The light transmission rate of the transparent electrode thus obtained was higher than 90% for visible rays of 400 to 700 nm, while the sheet resistance was measured at 150 to 180 Ω/□ (specific resistance $1.0 \times 10^{-3}$ Ω cm). The film had a stable resistance value without substantial secular change. The surface of this film was generally smooth, although the degree of smoothness slightly varies depending on the degree of concavities and convexities of the substrate. In addition, this film has an adequate resistance to washing with ordinary organic solvents.

Fig. 2f shows a conductive film 36 which makes ohmic contact on the other side of the substrate 20. Usually, this film 36 is earthed via a terminal.

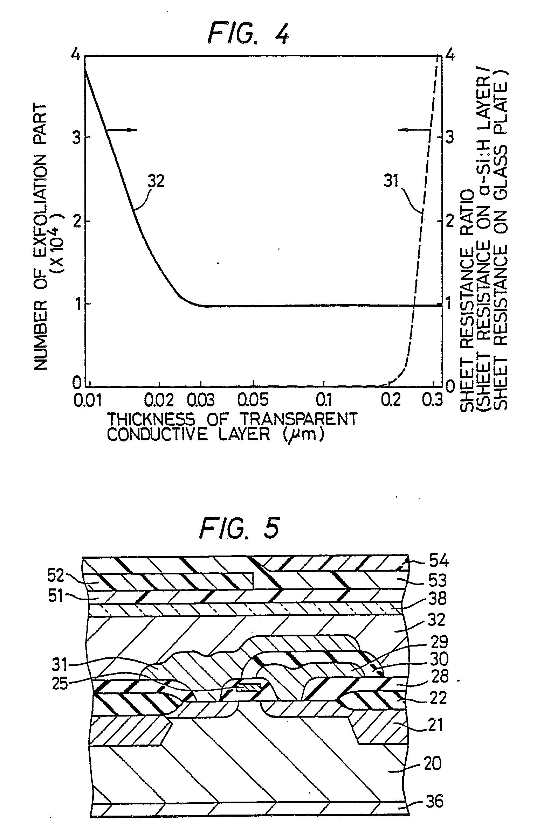

In Fig. 4 the broken line curve 31 represents the number of cases of peeling from the a-Si:H film in relation to the thickness of the transparent conductive film. It can be seen that this number is $4 \times 10^4$ when the film thickness of 0.3 μm, but is drastically decreased as the film thickness is decreased and is substantially zero when the film thickness is 0.2 μm (2000Å).

A full line curve 32 shows how the sheet resistance ratio of the transparent conductive film varies with change in the thickness of the film. The sheet resistance ratio is the ratio of the sheet resistance of the film on the a-Si:H film to the sheet resistance of the film formed on a glass sheet. The sheet resistance ratio takes a high level of 3.6 when the thickness of the film is 0.01 μm. The sheet resistance ratio, however, is gradually decreased as the film thickness increases. In fact, the sheet resistance ratio has a small value of 1 when the film thickness is 0.03 μm (300Å). This means that there is no substantial difference between the resistance value of the transparent conductive film formed on a smooth glass sheet and that of the same film formed on an a-Si:H film. It was confirmed that, when the film thickness exceeds 30 nm (300Å), the resistance value is maintained stably without being affected by the presence of convexities and concavities in the underlying layer. In consequence, solid state image pickup elements using such transparent conductive films having thicknesses between 30 and 200 nm (300Å and 2000Å) provide good images, without short-circuiting or abnormal fluctuation of the resistance value.

In the embodiment described above a solid solution of indium oxide and tin oxide was used for the transparent conductive film. However, equivalent results were obtained when the transparent conductive film is constituted solely of the indium oxide.

Although a MOS transistor is used as the electronic circuit formed on the substrate in the above embodiment, equivalent results were confirmed where other types of CCD (Charge Coupled Device) or other active or passive elements are used in place of the MOS transistor.

The device of Fig. 5 is a modification of the image pickup device shown in Fig. 1 for pickup of color images. The same reference numerals are used to denote the same parts as those in Fig. 1, and detailed description of such parts is omitted.

On the transparent electrode 38, as protective film 51 is formed to prevent mixing of color. This film 51 is made of poly(glycidyl metacrylate). Then, a cyan color filter 52 is formed by dyeing gelatine to a suitable color. A layer 53 of poly(glycidyl methacrylate) is formed on the color filter 52. Not shown is another color filter formed on another portion and also covered by a protective film to prevent mixing of color, a part 54 of this protective film being shown in the drawing. Needless to say, another protective film may be provided between the transparent electrode 38 and the protective film 51 to prevent mixing of color, or on the protective film 51. In general, color filters are formed in a plurality of layers for use in an image pickup device or the like. This laminated structure may be employed in this embodiment. The filters and the protective films for preventing mixing of color may be formed of other materials than those mentioned above.

**Claims**

1. A photoelectric converter comprising photoelectric conversion means formed on a substrate (20), said photoelectric conversion means including at least a first electrode (31), a hydrogenated amorphous silicon layer (32) and formed on said first electrode (31), the silicon in the layer being optionally substituted by at least one of germanium and carbon and a second electrode (38) in the form of a transparent conductive layer composed of $In_2O_3$ or a solid solution of $In_2O_3$ and $SnO_2$ and formed on said silicon layer (32) characterized in that said transparent conductive layer (38) has a thickness in the range 30 to 200 nm.

2. A photoelectric converter according to claim 1, wherein said substrate includes scanning means for successively scanning a plurality of said photoelectric conversion means, said first electrode constituting electric connecting means of said scanning means.

3. A photoelectric converter according to claim 2, wherein said substrate (20) is a semiconductor substrate, and a plurality of said first electrodes of said scanning means are arranged in a two dimensional array.

4. A photoelectric converter according to claim 2 or claim 3 having a color filter (52) formed on said transparent conductive layer (38).

## Revendications

1. Convertisseur photoélectrique comportant des moyens de conversion photoélectrique formés sur un substrat (20) et comprenant au moins une première électrode (31), une couche (32) de silicium amorphe hydrogéné formée sur ladite première électrode (31), le silicium dans la couche étant remplacé de façon optionnelle, par au moins l'un des éléments que sont le germanium et le carbone, et une seconde électrode (38) réalisée sous la forme d'une couche conductrice transparente constituée par du $In_2O_3$ ou par une solution solide de $In_2O_3$ et de $SnO_2$ et formée sur ladite couche en silicium (32), caractérisé en ce que ladite couche conductrice transparente (38) possède une épaisseur située dans la gamme comprise entre 30 et 200 nm.

2. Convertisseur photoélectrique selon la revendication 1, dans lequel ledit substrat comporte des moyens de balayage servant à balayer successivement une pluralité desdits moyens de conversion photoélectrique, ladite première électrode constituant des moyens de raccordement électrique desdits moyens de balayage.

3. Convertisseur photoélectrique selon la revendication 2, dans lequel ledit substrat (20) est un substrat semiconducteur, et une pluralité desdites premières électrodes desdits moyens de balayage sont disposées suivant un réseau bidimensionnel.

4. Convertisseur photoélectrique selon la revendication 2 ou 3, comportant un filtre coloré (52) formé sur ladite couche conductrice transparente (38).

## Patentansprüche

1. Fotoelektrischer Wandler mit auf einem Substrat (20) gebildeten fotoelektrischen Umwandlungseinrichtungen, die zumindest eine erste Elektrode (31), eine auf dieser ersten Elektrode (31) ausgebildete, hydrierte amorphe Siliziumschicht (32), wobei das Silizium in der Schicht wahlweise zumindest entweder durch Germanium oder durch Kohlenstoff substituiert ist, und eine zweite Elektrode (38) in Form einer transparenten leitfähigen Schicht umfassen, die aus $In_2O_3$ oder einer festen Lösung von $In_2O_3$ und $SnO_2$ zusammengesetzt und auf der genannten Siliziumschicht (32) ausgebildet ist, dadurch gekennzeichnet, daß die transparente leitfähige Schicht (38) eine Dicke im Bereich von 30 bis 200 nm aufweist.

2. Fotoelektrischer Wandler nach Anspruch 1, wobei das Substrat Abtasteinrichtungen für das aufeinanderfolgende Abtasten einer Vielzahl der fotoelektrischen Umwandlungseinrichtungen umfaßt, wobei die genannte erste Elektrode elektrische Verbindungseinrichtungen dieser Abtasteinrichtungen bildet.

3. Fotoelektrischer Wandler nach Anspruch 2, wobei das Substrat (20) ein Halbleitersubstrat ist, und eine Vielzahl der ersten Elektroden der Abtasteinrichtungen in einer zweidimensionalen Anordnung angeordnet ist.

4. Fotoelektrischer Wandler nach Anspruch 2 oder Anspruch 3, der einen auf der transparenten leitfähigen Schicht (38) gebildeten Farbfilter (52) aufweist.

# FIG. 1

## FIG. 2a

## FIG. 2b

## FIG. 2c

FIG. 2d

FIG. 2e

FIG. 2f

# FIG. 3

## FIG. 4

## FIG. 5